# EUROPEAN PATENT APPLICATION

(11) **EP 2 184 953 A1**
(43) Date of publication of application: **12.05.2010**
(21) Application number: 08829306.3
(22) Date of filing: 03.09.2008
(51) Int. Cl.: H05B 33/02, H01L 51/50, H05B 33/10, H05B 33/12, H05B 33/24

(54) **OPTICAL EXTRACTION ELEMENT, METHOD FOR MANUFACTURING THE OPTICAL EXTRACTION ELEMENT, AND DISPLAY DEVICE**

(30) Priority: 06.09.2007 JP 2007230940
(71) Applicant: Sony Corporation, Tokyo 108-0075 (JP)
(72) Inventor: WATANABE, Tatsuya, Tokyo 108-0075 (JP)
(74) Representative: Müller - Hoffmann & Partner
(86) International application number: PCT/JP2008/065847
(87) International publication number: WO 2009/031571

(57) **Abstract**

[Object] To provide a light extraction device having a reflector function and a color filter function.

[Solving Means] A light extraction device (23) according to an embodiment of the present invention includes a translucent portion (26) having a reflection surface for changing an exit angle of light from a light-emitting layer (21), and at least a part of the translucent portion (26) is formed as color filters (26R, 26G, 16B). The translucent portion (26) has a function as a reflector for changing the exit angle of light from the light-emitting layer (21), and improves an extraction efficiency of light from the light-emitting layer (21) to an air layer (8). Further, the at least a part of translucent portion (26) is formed as the color filters, and therefore a reflector and the color filter can be formed on the same layer. With this structure, the light extraction device having the reflector function and the color filter function can be obtained.

## Description

### Technical Field

The present invention relates to a light extraction device that is provided on a display surface of a self-light-emitting display such as an organic electro-luminescence display to improve a light extraction efficiency thereof, a manufacturing method of the same, and a display apparatus provided with the light extraction device.

### Background Art

In recent years, a display apparatus using a self-light-emitting device such as a light-emitting diode (LED) and an electro-luminescence (EL) device is being vigorously developed. A light-emitting portion of the self-light-emitting device of this type is structured so as to have a higher refractive index than an air layer, which causes an inconvenience in that light generated cannot be efficiently extracted to outside. Therefore, there is a demand for improvement of a light extraction efficiency. Further, measures of increasing a color purity and a contrast are being taken.

As a devise for increasing the light extraction efficiency, a structure in which a reflector is provided on a light exit surface of a light-emitting layer is known (see, for example, Patent Document 1). A structural example of a typical reflector is shown in Fig. 7.

A light-emitting layer 1 including light-emitting devices 1R, 1G, and 1B of red (R), green (G), and blue (B) are formed on a front surface of a panel substrate 2, and a reflector 3 is bonded on a light exit surface of the light-emitting layer 1 through a bonding layer 4. The reflector 3 includes a transparent substrate 5, and on an inner surface side of the transparent substrate 5, a plurality of translucent portions 6 for guiding exit light from the light-emitting layer 1 are provided. The translucent portions 6 are arranged so as to respectively correspond to the respective light-emitting devices. Each translucent portion 6 is a structure which has an inverse truncated cone shape and which is formed of a translucent resin material, for example. On a side peripheral surface thereof that is inclined, a reflection film 7 is formed. The bonding layer 4, the transparent substrate 5, and the translucent portion 6 have similar refractive indexes (1.5 to 1.6), and the light-emitting layer 1 generally has a larger refractive index (1.8 or more) than these.

Refraction of light on a boundary surface between dissimilar media is governed by Snell's law. In a case where light travels from a medium having a refractive index of n1 to a medium having a refractive index of n2, under a condition of n1 > n2, when light incident angle θ with respect to the boundary surface is a critical angle (sin⁻¹(n2/n1)) or more, light is totally reflected on the boundary surface. Therefore, light cannot be extracted to outside.

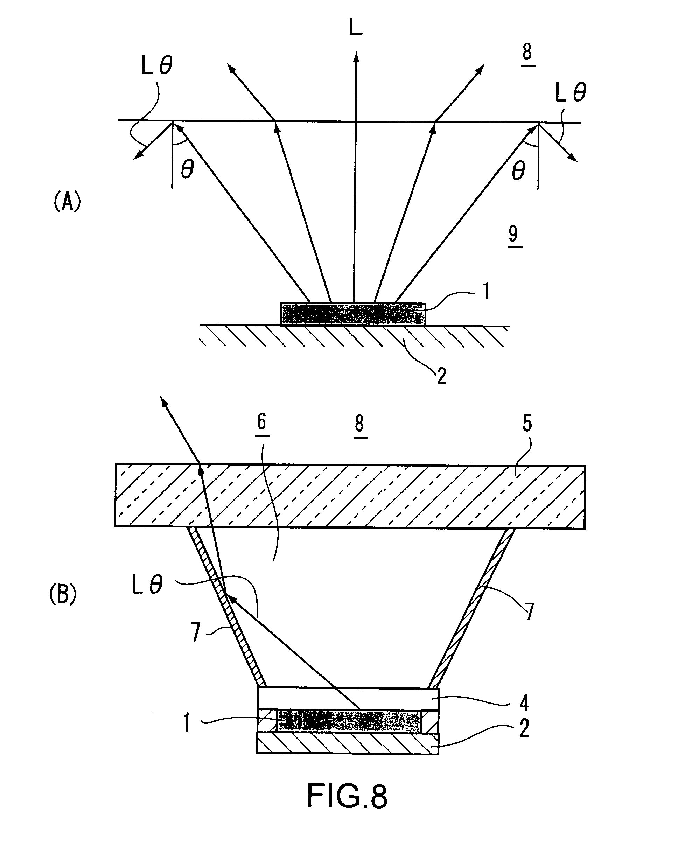

Here, in a case where the reflector 3 is not provided, as shown in Fig. 8(A), light L emitted from the light-emitting layer 1 is emitted to an air layer 8 through a translucent layer 9 that covers the light-emitting layer 1. However, because the translucent layer 9 has a higher refractive index than the air layer 8, light Lθ whose incident angle θ to the boundary surface between the air layer 8 and the translucent layer 9 is equal to or larger than the critical angle is totally reflected on the boundary surface, and thus cannot be extracted to a side of the air layer 8. Therefore, an extraction efficiency of exit light from the light-emitting layer 1 is significantly restricted according to an exit angle of light from the light-emitting layer 1.

In contrast, in a case where the reflector 3 is provided, as shown in Fig. 8(B), light emitted from the light-emitting layer 1 is emitted to the air layer 8 through the translucent portion 6 and the transparent substrate 5. Out of this light, light emitted from the light-emitting layer 1 at an exit angle corresponding to the light Lθ shown in Fig. 8(A) is reflected by a side surface of the translucent portion 6, and directed toward the transparent substrate 5 side by changing the exit angle. Accordingly, the incident angle of the light (Lθ) to the boundary surface between the transparent substrate 5 and the air layer 8 becomes smaller than the critical angle, and therefore the light (Lθ) is refracted at a predetermined refraction angle and is emitted to the air layer 8 side. As a result, the extraction efficiency of the light emitted from the light-emitting layer 1 can be improved.

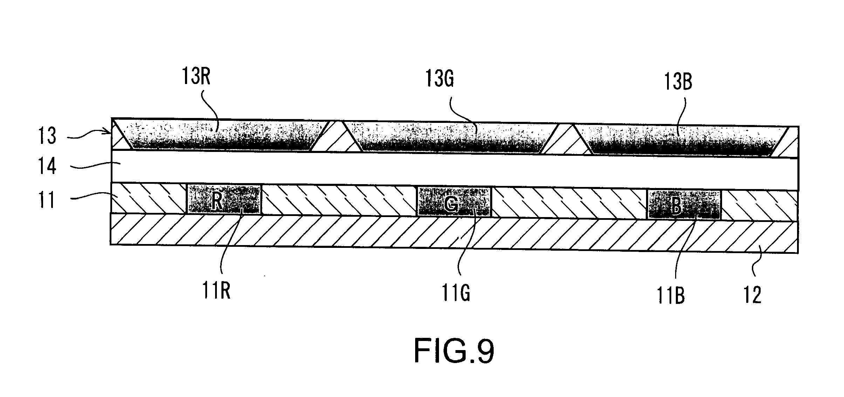

On the other hand, as measures to improve a color purity or a contrast of the light-emitting device, a structure in which a color filter is provided on a front surface of a panel (see, for example Patent Document 2). An example of disposing a color filter to a self-light-emitting display is shown in Fig. 9.

In Fig. 9, a light-emitting layer 11 including light-emitting devices 11R, 11G, and 11B of red (R), green (G), and blue (b) is formed on a front surface of a panel substrate 12, and a color filter 13 is bonded to a light exit surface of the light-emitting layer 11 through a bonding layer 14. The color filter 13 includes a red filter portion 13R, a green filter portion 13G, and a blue filter portion 13b, and the filter portions of these colors are arranged so as to correspond to the light-emitting devices 11R, 11G, and 11B of the same colors, respectively.

By providing the color filter on the front surface of the light-emitting layer 1, the color purity can be improved and the reflection of outside light can be suppressed. Therefore, a bright place contrast can be improved.

Patent Document 1: Japanese Patent No. 3573393
Patent Document 2: Japanese Patent Application Laid-open No. 2005-322623

### Disclosure of the Invention

### Problem to be solved by the Invention

The two devices (reflector 3, color filter 13) described above are useful for improving characteristics of the self-light-emitting display. However, a desired effect cannot be expected if the both devices are not brought closer to the light-emitting device.

The light extraction efficiency of the reflector becomes higher as the reflector is brought closer to the light-emitting device. In contrast, when the reflector and the light-emitting device are set apart by a predetermined distance or more, the light extraction efficiency becomes lower. On the other hand, similarly, when the color filter is distanced from the light-emitting device, a crosstalk (exit light from a light-emitting device of a certain color passes through a filter portion of another color which is adjacent thereto) occurs. Therefore, in a case where the two devices are attached to the display, when one of the devices is brought closer to the display, the other device is distanced from the display, which makes it extremely difficult to provide the two devices to the display in a state where desired optical characteristics can be exerted.

Further, there are problems in that the use of the two devices described above for improving the light extraction efficiency, the color purity, and the like causes complication of the structure of the display apparatus and increase in cost, and further causes reduction in yield or increase in manufacturing cost due to increase in number of bonding processes.

The present invention has been made in view of the above-mentioned problems, and has an object to provide a light extraction device having a reflector function and a color filter function, a manufacturing method of the same, and a display apparatus including the same.

### Means for solving the Problem

To solve the above-mentioned problems, the light-emitting device according to an aspect of the present invention is provided on a light exit surface of a light-emitting layer and includes a translucent portion including a reflection surface for changing an exit angle of light from the light-emitting layer, and at least a part of the translucent portion is formed as a color filter.

The light extraction device includes the translucent portion and the reflection surface. The translucent portion contains a colorant and causes light emitted from the light-emitting layer to pass therethrough. The reflection surface is formed on a periphery of the translucent portion and changes the exit angle of light from the light-emitting layer.

Because the reflection surface has a function as a reflector for changing the exit angle of light from the light-emitting layer, the light extraction efficiency from the light-emitting layer to an air layer can be improved. Further, because the translucent portion contains the colorant, the reflector and the color filter can be formed on the same layer. With this structure, the light extraction device having a reflector function and a color filter function can be obtained.

In the light extraction device mentioned above, a structure thereof can be simplified, and at the same time, only one bonding process to the light-emitting layer is required, which can prevent increase in the number of manufacturing processes. Further, an arrangement distance between the reflector and the color filter with respect to the light-emitting layer can be optimized, and thus excellent optical characteristics of providing high light extraction efficiency and preventing the crosstalk can be easily obtained.

In the light extraction device mentioned above, the translucent portion can include a structure made of a translucent resin, a reflection film formed on a side peripheral surface of the structure, and a colored layer constituting at least a part of the structure. The translucent resin can be formed of an energy beam curable resin that is cured by performing irradiation with an energy beam such as an ultraviolet ray and an electron beam. The reflection surface can be formed into a plane shape or a curved shape. By appropriately adjusting an angle of inclination, a curvature, or the like of the reflection surface, a desired optical orientation can be imparted to the exit light.

The colored layer can be formed by dispersing or dissolving a colorant into the translucent resin. The colorant includes a pigment and a dye. As an example of forming the whole structure by the colored layer, a method of molding the structure by the translucent resin containing the colorant can be given.

In addition, as an example of forming a part of the structure by the colorant, a method of molding the structure by using the translucent resin containing the colorant and a translucent (i.e., transparent) resin that does not contain the colorant can be given. In this case, it is possible to freely set a density and a thickness of the colored layer in order to obtain an intended optical density. A boundary between the colored layer and the transparent layer may be a flat or curved surface. In addition, the boundary between the colored layer and the transparent layer is not required to be clear, and may have a structure in which the density of the colorant is gradually changed, for example.

On the other hand, a manufacturing method of a light extraction device according to an aspect of the present invention includes a process of preparing a molding substrate in which a plurality of concave portions are two-dimensionally arranged on a surface thereof. In to the concave portions, the translucent resin containing the colorant is supplied. The translucent resin is cured and transferred onto a transparent substrate. On a side peripheral surface of the structure made of the translucent resin cured, a reflection film is formed.

The translucent portion mentioned above can be structured as a molded body of the translucent resin using the concave portions of the molding substrate. By using an energy beam curable resin such as an ultraviolet curable resin for the translucent resin, the translucent resin in each concave portion is cured through the transparent substrate, and then the structure can be easily transferred onto the transparent substrate from the molding substrate. The reflection film can be formed by a physical vapor deposition method such as a vacuum vapor deposition method and a sputtering method.

The molding substrate may be formed of a rigid substrate having a high rigidity, or may be formed of a flexible substrate having flexibility. To supply the translucent resin containing the colorant into the concave potions, an ink-jet method can be used.

Further, a display apparatus according to an aspect of the present invention includes a light-emitting layer, a translucent portion, and a reflection surface. The translucent portion contains a colorant and causes light emitted from the light-emitting layer to pass therethrough. The reflection surface is formed on a periphery of the translucent portion and changes an exit angle of light from the light-emitting layer.

In the display apparatus described above, the structure can be simplified, and at the same time, only one bonding process with respect to the light-emitting layer is required, which can prevent increase in the number of manufacturing processes. In addition, it is possible to optimize an arrangement distance between the reflector and the color filter with respect to the light-emitting layer, and therefore excellent optical characteristics of providing a high light extraction efficiency and preventing a crosstalk can be easily obtained.

### Effect of the Invention

According to the present invention, the light extraction device having the reflector function and the color filter function can be obtained.

### Best Modes for Carrying Out the Invention

Hereinafter, embodiments of the present invention will be described with reference to the drawings.

### <First embodiment>

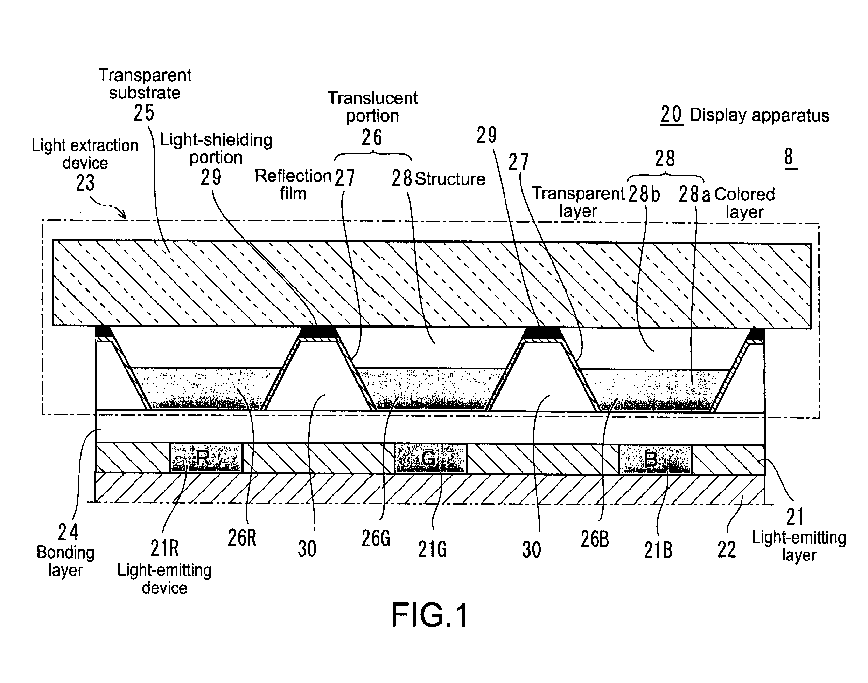

Fig. 1 is a cross-sectional diagram showing a schematic structure of a light extraction device and a display apparatus provided with this according to a first embodiment of the present invention. A display apparatus 20 of this embodiment includes a light-emitting layer 21 including light-emitting devices 21R, 21G, and 21B of red (R), green (G), and blue (B), respectively, that constitute a light-emitting pixel area. The light-emitting layer 21 is formed on a front surface of a panel substrate 22, and a light extraction device 23 is provided on a light exit surface of the light-emitting layer 21, thereby structuring the display apparatus 20.

The light-emitting devices 21R, 21G, 21B are each formed by a known self-light-emitting device, such as a light-emitting diode (LED) and an organic or inorganic electro-luminescence (EL) device, whose emitting light brightness is adjusted in accordance with a magnitude of an input current. Further, these light-emitting devices are constituted of light-emitting devices of colors of R, G, and B, but the colors of emitted light are not limited to those colors and may partly or entirely be constituted of white light-emitting devices.

In this embodiment, the light extraction device 23 is bonded with the front surface (light exit surface) of the light-emitting layer 21 through a bonding layer 24. The bonding layer 24 is made of a transparent bonding material, and bonds the light-emitting layer 21 and the light extraction device 23 with each other at an appropriate distance therebetween.

The light extraction device 23 is an optical device having a reflector function and a color filter function as described later. The light extraction device 23 includes a translucent portion 26 having a reflection surface (reflection film 27) for changing light exit angle from the light-emitting layer (light-emitting device) 21, and at least a part of the translucent portion 26 is formed as a color filter (colored layer 28a).

The light extraction device 23 of this embodiment 23 includes the translucent portion 26 that causes light emitted from the light-emitting layer 21 to pass therethrough and the reflection film 27 (reflection surface) that is formed on the periphery of the translucent portion 26 and changes a light exit angle from the light-emitting layer 21. The translucent portion 26 is formed of a structure 28 including the colored layer 28a and a transparent layer 28b. The reflection film 27 is formed on a side peripheral surface of a structure 48.

The translucent portion 26 includes the structure 28 made of a translucent resin, the reflection film 27 formed on the side peripheral surface of the structure 28, and the colored layer 28a for coloring at least a part of the structure 28.

The structure 28 has an inverse truncated cone shape in Fig. 1, and on an inclined side peripheral surface thereof, the reflection film 27 is formed. As described later, the structure 28 is molded by using a molding substrate in which a concave portion of the inverse truncated cone shape is formed. As the translucent resin that forms the structure 28, an ultraviolet curable resin, in particular, a material having a similar refractive index to an adhesion layer 24 is used. Specifically, in a case where the bonding layer 24 is formed of an ultraviolet curable resin whose refractive index is, e.g., 1.5 to 1.6, a resin material of the same type is used as the translucent resin that forms the structure 28. It should be noted that a thermosetting resin may be used for the bonding layer 24.

The reflection film 27 is formed of a vapor deposition film or a sputtered film that are formed by using a metal film such as aluminum and silver by a physical vapor deposition method such as a vacuum vapor deposition method and a sputtering method. As the reflection film 27, a resin film made of white PET or the like may be used. The reflection film 27 is formed so as to structure a reflection surface of the translucent portion 26 and cover the side peripheral surface of the molded structure 28. Accordingly, in the case where the structure 28 has a rotationally symmetric shape like the inverse truncated cone shape, the reflection surface is formed into a curved surface shape.

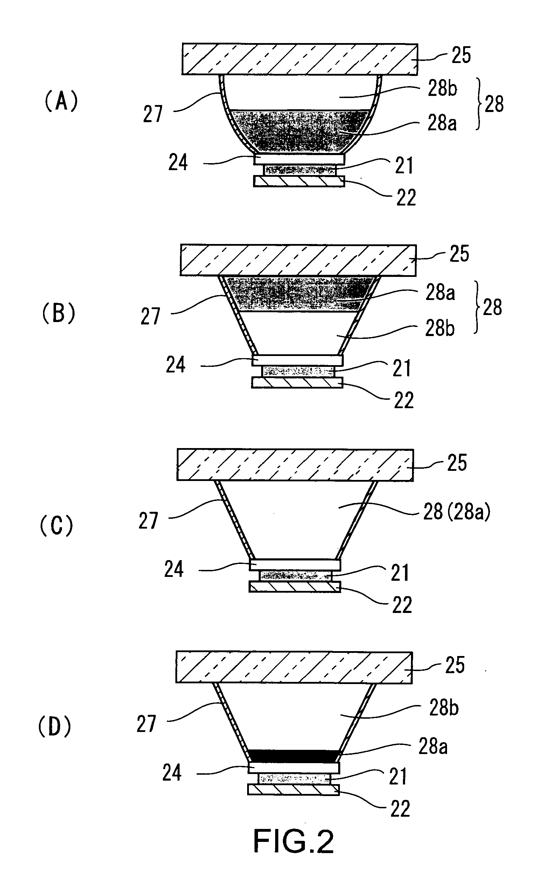

In addition, in the case where a cross-sectional form of the side peripheral surface of the structure 28 is linear, the reflection film 27 formed thereon is also linear as shown in Fig. 1. In contrast, when a cross-sectional form of the side peripheral surface of the structure 28 is curved as shown in Fig. 2(A), the reflection film 27 formed thereon is also curved as shown in the figure. Kinds of the curved line (or curved surface) are not particularly limited, and the shape of the reflection surface can be arbitrarily set to a hyperbolic curve, a spherical surface, an aspherical surface, or the like in accordance with an application, a specification, or the like of the display apparatus 20.

For example, in the case of the translucent portion 26 having the structure of the reflection surface that is rotationally symmetric as in this embodiment, the reflector has radiation angle characteristics that are uniform with respect to all angles. In this case, light distribution characteristics of providing large divergence angles and wide view angles, which change depending on the shape of the side peripheral surface of the structure 28 are effective for a television use, and light distribution characteristics of providing a high light collection property and narrow view angles are effective for a mobile use. On the other hand, in a case of providing view-angle characteristics different in a horizontal direction and in a vertical direction by forming the shape of the translucent portion into an inverse truncated quadrangular pyramid, instead of the rotationally symmetrical shape, the reflection surface is formed into a plane. In this case, it is possible to work out a design such that a view angle is widened in a specific direction or a design such that peeping from a specific direction is prevented.

Next, the colored layer 28a will be described. The colored layer 28a is formed by dispersing or dissolving a colorant into a translucent resin. For the colorant, for example, a pigment or dye of red, green, blue, or the like is used. The structure 28 shown in Fig. 1 has a bilayer structure constituted of the colored layer 28a made of the translucent resin containing the colorant and the transparent layer 28b made of the translucent resin that does not contain the colorant. These colored layer 28a and transparent layer 28b are molded in the same molding substrate and integrated as described layer.

In the example shown in Fig. 1, first, the translucent resin containing the colorant is supplied into a mold, and then the mold is filled with the translucent resin that does not contain the pigment and that is transparent. The translucent resin containing the colorant is also formed of the ultraviolet curable resin of the same type as the translucent resin that does not contain the colorant and is transparent, but is not limited to this. It should be noted that by injecting these resins in a reverse order, the colored layer 28a and the transparent layer 28b can be tuned upside down as shown in Fig. 2(B).

A density of the colorant contained in the colored layer 28a and a thickness of the colored layer are determined in accordance with a design of the color purity of light that passes through the translucent portion 26. In other words, a thick colored layer having a low density may be formed, or thin colored layer having a high density may be formed. Therefore, an intended optical density can be obtained, and thus a degree of freedom in design can be improved in accordance with the size of the structure, a restriction on a process, or the like. Fig. 2(C) shows an example in which the colored layer 28a having a low density entirely forms the structure 28, and Fig. 2(D) shows an example in which the colored layer 28a having a high density is formed to be thin on a bottom portion of the structure 28. For example, in a case where the colored layer having a relatively high density is formed by using the pigment for the colorant, there is a possibility that a clogging may occur in an ejection nozzle of the resin. In this case, by thickly forming a colored layer having a relatively low density, an intended optical density can be easily obtained.

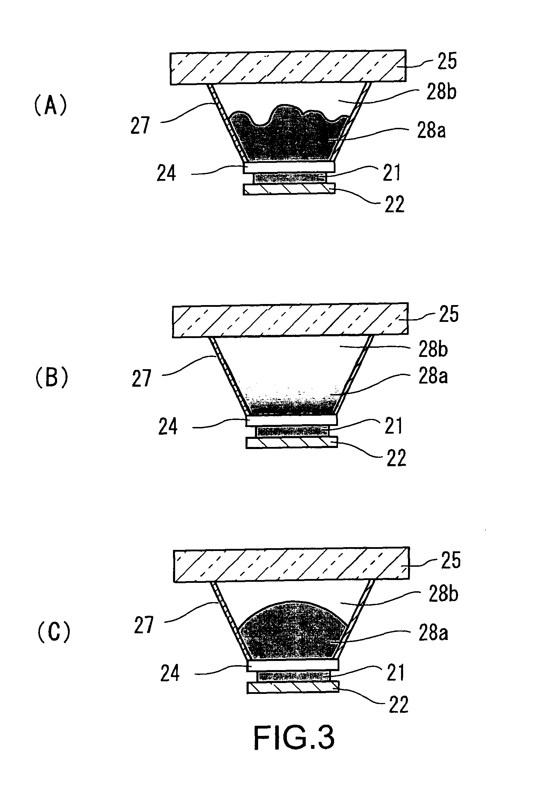

A boundary between the colored layer 28a and the transparent layer 28b is not limited to a case of being flat. For example, as shown in Fig. 3(A), the boundary between the colored layer 28a and the transparent layer 28b may have an irregular, uneven form. Alternatively, as shown in Fig. 3(B), a form in which the boundary between the colored layer 28a and the transparent layer 28b is vague and the density of the colored layer 28a is gradually decreased in the vicinity of the boundary may be provided. In this case, it is possible to suppress reflection of light on a surface of the boundary due to a difference of refractive indexes between the colored layer 28a and the transparent layer 28b. Meanwhile, as shown in Fig. 3(C), by using a surface tension of the colored layer 28a, the boundary surface between the colored layer 28a and the transparent layer 28b may be formed into a curved surface shape. With this structure, a predetermined lens effect can be obtained on the boundary surface, which can improve the degree of freedom in designing of the light distribution characteristics.

It should be noted that the example in which the colored layer 28a and the transparent layer 28b constitute the structure 28 in a separate form without being mixed is described above, but the structure 28 may be constituted in a state where the colored layer 28a and the transparent layer 28b are mixed with each other.

Light emitted from the light-emitting layer 21 is extracted to an air layer 8 through the light extraction device 23. At this time, by structuring the light extraction device 23 so that the refractive index is gradually reduced from the light-emitting layer 21 side toward the air layer 8 side, the reflection of light on an interface between the layers can be suppressed. As a result, the extraction efficiency of light to the air layer 8 can be enhanced. Generally, the colored layer containing the colorant has a higher refractive index than the transparent layer that does not contain the colorant. Therefore, it may be said that the structural examples shown in Fig. 2(A), Fig. 2(C), Fig. 2(D), and Fig. 3(A) to Fig. 3(C) are advantageous for improving the extraction efficiency of light, because it is possible to gradually reduce the refractive index in a traveling direction of light.

The light extraction device 23 includes a plurality of translucent portions 26 structured as described above, and also includes a transparent substrate 25 for supporting these translucent portions 26. An arrangement pitch of the translucent portions 26 corresponds to an arrangement pitch of the light-emitting devices, and is 90 µm, for example. In this case, a height of each translucent portion 26 is 50 µm, for example. The transparent substrate 25 is formed of a glass substrate, but may be formed of a plastic substrate. The refractive index of the transparent substrate 25 can be equal to that of the translucent resin that forms the translucent portion 26.

The plurality of translucent portions 26 are two-dimensionally arranged so as to correspond to the light-emitting devices 21R, 21G, and 21B, respectively, and the respective colored layers 28a are structured in colors corresponding to emitted light colors of the light-emitting devices. That is, the translucent portion 26 directly above a red light-emitting device 21R has a red colored layer 28a (26R), the translucent portion 26 directly above a green light-emitting device 21G has a green colored layer 28a (26G), and the translucent portion 26 directly above a blue light-emitting device 21B has a blue colored layer 28a (26B).

Between the translucent portions 26 adjacent, a light-shielding portion 29 is formed. The light-shielding portion 29 is used mainly for absorbing outside light, and suppresses deterioration in image quality of a display image due to reflection of the outside light. The light-shielding portion 28 is made of a black resin material containing a carbon black, for example. Further, an area 30 formed between the adjacent translucent portions 26 is filled with a transparent or opaque resin material, thereby flattening a bonding interface between the light extraction device 23 and the light-emitting layer 21. It should be noted that the area 30 may be a mere space portion (air layer).

In the display apparatus 20 of this embodiment structured as described above, the light-emitting devices 21R, 21G, and 21B respectively constitute individual pixels. Further, the translucent portions 26 of the light extraction device 23 are arranged so as to correspond to the respective light-emitting devices. Therefore, light emitted from each of the light-emitting devices is emitted to the external air layer 8 through the adhesion layer 24, the translucent portion 26, and the transparent substrate 25.

Each of the translucent portions 26 of the light extraction device 23 has a mortal shape whose opening size is increased from the light-emitting layer 21 toward the transparent substrate 25, and the reflection film 27 is formed on a side peripheral surface thereof. Accordingly, out of light emitted from the light-emitting layer 21, light that has reached the side peripheral surface of the translucent portion 26 is reflected by the reflection film 27 and an optical path thereof is changed, thereby changing an exit angle. Therefore, an incident angle to the boundary surface between the transparent substrate 25 and the air layer 8 is limited, and a rate of light that is totally reflected by the boundary surface is significantly reduced, with the result that an extraction amount of light can be increased.

Further, the color purity of light passing through the translucent portion 26 is increased by the colored layer 28a, which can improve a color reproducibility of an image. In addition, the colored layer 28a of each translucent portion 28 has an effect of significantly reducing the reflection of outside light, and thus a bright place contrast is significantly improved.

As described above, according to this embodiment, the light extraction device 23 that has the reflector function and the color filter function can be formed. Thus, as compared to a case where the reflector and the color filter are separately provided, the number of parts can be reduced, and the number of bonding processes to the display can be one.

Further, the reflector and the color filter can be provided near the light-emitting layer 21. Accordingly, by adjusting the thickness of the bonding layer 24, an optimal provision condition on which effects of both the functions can be exerted at the same time is realized, and excellent optical characteristics of providing a high light extraction efficiency and preventing a crosstalk can be easily obtained.

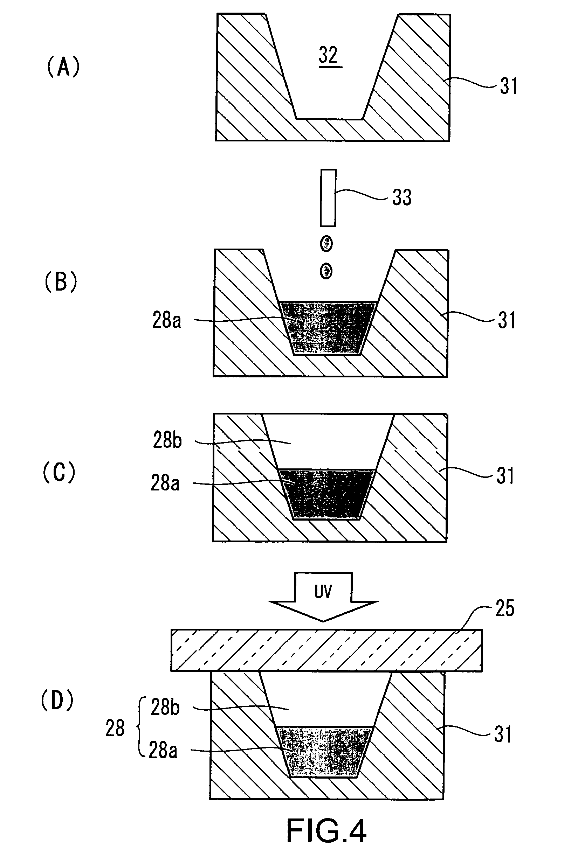

Next, a manufacturing method of the light extraction device 23 structured as described above will be described with reference to Fig. 4 to Fig. 6. Fig. 4 to Fig. 6 are process cross-sectional diagrams for explaining the manufacturing method of the light extraction device 23.

First, as shown in Fig. 4(A), a molding substrate 31 on a surface of which a plurality of (single in the figure) concave portions 32 are two-dimensionally arranged is prepared. The shape of the concave portion 32 corresponds to the shape of the translucent portion 26. It should be noted that the molding substrate 31 is made of a metal material. The manufacturing method of the molding substrate 31 is not particularly limited, and the molding substrate 31 can be manufactured as follows, for example.

With respect to a polycarbonate substrate, a convex portion that corresponds to the shape of the translucent portion 26 is formed by a mask imaging method using a KrF excimer laser. Next, the polycarbonate substrate is subjected to Ni electroforming, with the result that a metal mold (molding substrate 31) having the concave portion 32 corresponding to the shape of the convex portion can be obtained. It should be noted that the manufacturing method of the metal mold is not limited to the above example, and the metal mold may be directly processed by using a bite, a focused laser, or the like.

Next, as shown in Figs. 4(B) and (C), an ultraviolet curable resin that is a material of the colored layer 28a is dropped into the convex portion 32 by using a nozzle 33, and then an ultraviolet curable resin that is a material of the transparent layer 28b is supplied to the convex portion 32. For dropping the colored resin, an ink-jet method can be adopted. The convex portion 32 is filled with a transparent resin. For filling with the transparent resin, a coating method or a printing method can be adopted, but the ink-jet method may of course be adopted.

Subsequently, as shown in Fig. 4(D), the transparent substrate 25 is provided on the surface of the molding substrate 31, then the molding substrate 31 is irradiated with an ultraviolet ray (UV) from above the transparent substrate 25, to cure the resin, and the structure 28 constituted of the colored layer 28a and the transparent layer 28b is molded. At the same time, the structure 28 molded and the transparent substrate 25 are integrally bonded.

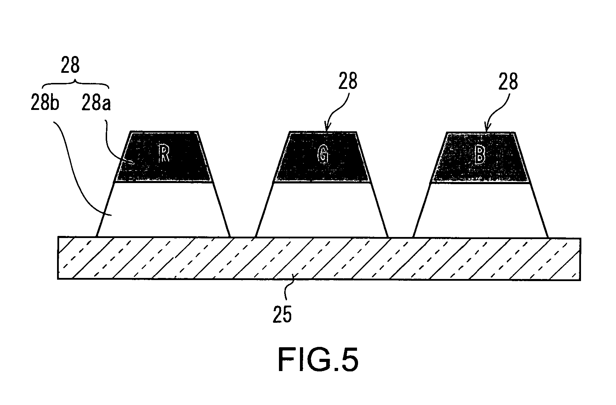

Next, as shown in Fig. 5, the transparent substrate 25 is detached from the molding substrate 31. The respective structures 28 formed by the process of curing the translucent resin are integrally bonded to the transparent substrate 25. Therefore, when the transparent substrate 25 is detached from the molding substrate 31, the respective structures 28 are transferred onto the transparent substrate 25 from the molding substrate 31. In a state where the respective structures 28 are supported on the transparent substrate 25, a process of forming the light-shielding portion and a process of forming the reflection film are carried out.

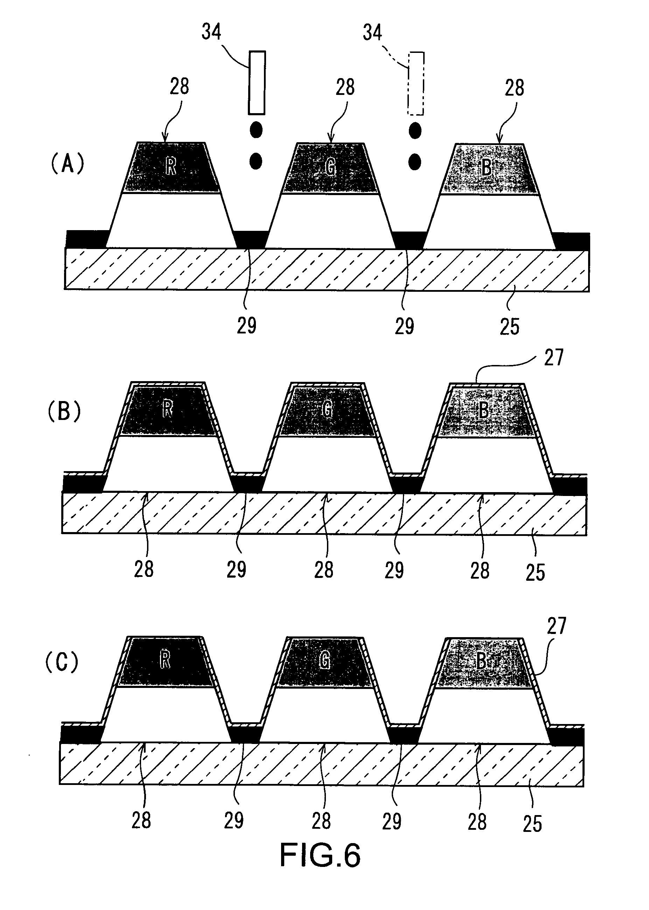

Fig. 6A shows the process of forming the light-shielding portion. The ink-jet method can be used for forming the light-shielding portion 29, and a blacking is dropped between the adjacent structures 28 from an ejection nozzle 34. For a base resin of the blacking, an ultraviolet curable resin is used, for example.

Next, the process of forming the reflection film is carried out. In this process, first, as shown in Fig. 6(B), the reflection film 27 is formed so as to cover the structures 28 and the light-shielding portions 29. As a method of forming the reflection film 27, the vacuum vapor deposition method or the sputtering method can be used. Next, as shown in Fig. 6(C), the reflection film 27 formed on a surface corresponding to a top portion of the structure 28 is removed by a lapping method or the like. Accordingly, the reflection film 27 is formed only on the side peripheral surface of the structure 28 and on the surface of the light-shielding portion 29.

It should be noted that a method in which a resist is formed on the top portion of the structure 28 in advance, the reflection film is formed, and then the resist layer is removed, thereby removing the reflection film from only an area of the top portion of the structure 28 may be adopted (lift-off method). In this case, the resist layer can be formed in advance on a bottom portion of a forming mold (concave portion 32) of the structure 28.
After that, the area 30 between the structures 28 is filled with a predetermined filler as necessary.

The light extraction device 23 of this embodiment is manufactured as described above. According to this embodiment, at least a part of the structure 28 constituting the reflector has a structure including the colored layer 28a that functions as the color filter, and therefore the reflector and the color filter are manufactured at the same time. Thus, the light extraction device 23 having the reflector function and the color filter function can be efficiently manufactured, and a manufacturing yield can be increased to improve productivity.

### <Second embodiment>

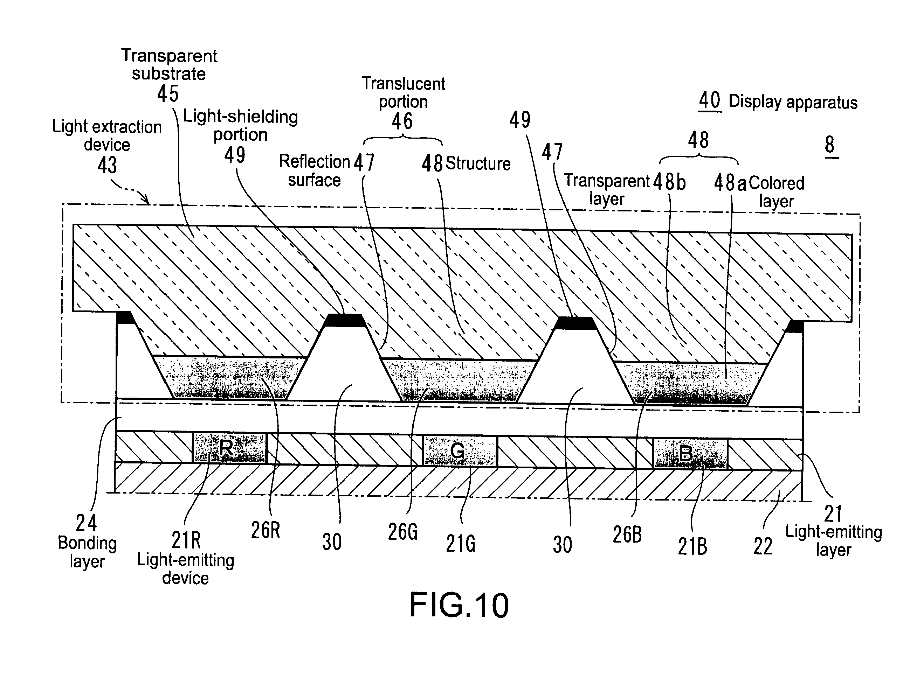

Fig. 10 is a cross-sectional diagram showing a schematic structure of a light extraction device and a display apparatus including this according to a second embodiment of the present invention. In a display apparatus 40 of this embodiment, a structure of a light extraction device 43 that is bonded to the light-emitting layer 21 through the bonding layer 24 is different from that of the light extraction device 23 according to the first embodiment.

The light extraction device 43 includes a translucent portion 46 that causes light emitted from the light-emitting layer 21 to pass therethrough, a reflection surface 47 that is formed around the translucent portion 46 and changes an exit angle of light from the light-emitting layer 21. The translucent portion 46 is constituted of a structure 48 including a colored layer 48a and a transparent layer 48b. The reflection surface 47 is formed on an interface between a side peripheral surface of the structure 48 and the space portion 30 formed between the structures 48 adjacent. A light-shielding portion 49 is formed between the adjacent structures 48.

The transparent layer 48b is formed on a transparent substrate 45 integrally therewith. A plurality of transparent layers 48b are formed so as to correspond to light-emitting pixel regions (light-emitting devices 21R, 21G, and 21B) of the light-emitting layer 21. The colored layer 48a is formed on an end of the transparent layer 48b. The colored layer 48a can be formed of a coating material made of a translucent resin containing a colorant. In this case, by coating or transferring the coating material on the end of the transparent layer 48b, the colored layer 48a can be formed. The colored layer 48a can also be structured by a colored layer of a color filter. Colors of the colored layers 48a correspond to colors of emitted light from the light-emitting devices 21R, 21G, and 21B opposed thereto, respectively.

The transparent substrate 45 can be formed of a translucent material such as glass, plastic, and ceramics. In this embodiment, the transparent layers 48b are formed by performing microfabrication on one surface of the transparent substrate 45.

For example, on the surface of the transparent substrate 45, a resist mask for covering a formation area of the transparent layer 48a is formed, and the surface of the transparent substrate 45 is etched with the resist mask being an etching mask. An etching process may be a dry etching method or a wet etching method. In a case where the transparent substrate 45 is made of glass, plasma of a gas containing fluorine (CF gas, SF gas, etc.) can be used for the dry etching process, for example. Further, for the wet etching process, an etching liquid such as a dilute hydrofluoric acid can be used. By forming the transparent layer 48b by using an etching technique, the transparent layer 48b having a truncated cone shape or a truncated quadrangular pyramid shape can be easily formed.

It should be noted that the transparent layer 48b can be formed by laser processing or bite processing with respect to the surface of the transparent substrate 45.

The reflection surface 47 is formed on the interface between the side periphery surface of the structure 48 and the space portion 30. The space portion 30 can be structured by an air layer. Further, the space portion 30 can also be filled with a material whose refractive index is lower than the structure 48. As a difference between the refractive index of the structure 48 and that of the space portion 30 becomes larger, a total reflection condition on the reflection surface 47 can be relaxed. Thus, the light extraction efficiency can be increased.

It should be noted that the reflection surface 47 may be formed by forming a reflection film on the side peripheral surface of the structure 48. The reflection film can be formed of a metal film such as silver and aluminum, a white coating material, or the like.

In the display apparatus 40 of this embodiment structured as described above, the same operation and effect as in the first embodiment can also be obtained. In particular, according to this embodiment, the structure 48 (transparent layer 48b) can be formed by surface fabrication of the transparent substrate 45.

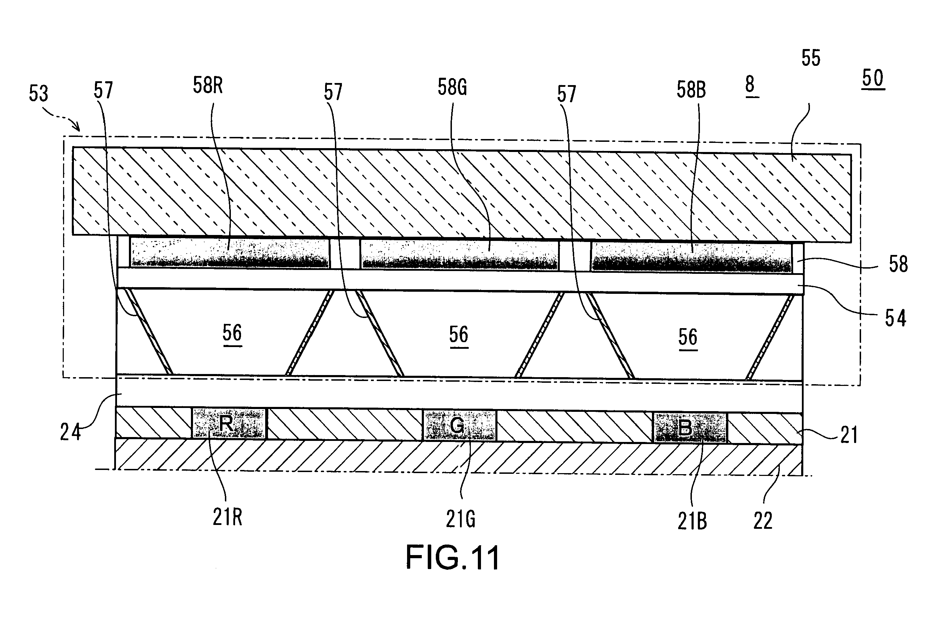

Fig. 11 is a schematic structural diagram of a display apparatus 50 shown as a comparative example of this embodiment. The display apparatus 50 according to this comparative example has a structure in which a light extraction device 53 is bonded to a light exit surface of the light-emitting layer 21 through the bonding layer 24. The light extraction device 53 has a layered structure of a transparent substrate 55, a color filter 58, and a translucent portion 56. The color filter 58 is directly formed on the transparent substrate 55, and the translucent portion 56 is bonded on the color filter 58 through the bonding layer 54. The bonding layer 54 is a layer provided between a reflector (translucent portion 56) and a color filter (color filter 58) in a broad sense, and includes a resin layer and the like generated between a reflector portion and a color filter portion in a case where the reflector is directly formed on a color filter substrate in a transfer process, for example. The translucent portion 56 is formed of a molded body of a transparent resin material which has an inverse truncated cone shape in Fig. 10. A plurality of translucent portions 56 are arranged so as to correspond to colored areas (58R, 58G, and 58B of the color filter 58. On the side peripheral surface of the translucent portion 58, a reflection film 57 formed of a metal film, a white resin film, or the like is formed. The light extraction device 53 is integrated with the light-emitting layer 21 by bonding the translucent portion 56 to the bonding layer 24.

In the display apparatus 50 according to the comparative example having the structure as described above, light emitted from the light-emitting layer 21 is emitted to the air layer 8 through the bonding layer 24, the translucent portion 56, the bonding layer 54, the color filter 58, and the transparent substrate 55. At this time, light emitted toward the side peripheral surface of the translucent portion 56 is reflected by the reflection film 57, thereby changing the exit angle thereof. As a result, an incident angle on the boundary surface between the transparent substrate 55 and the air layer 8 becomes smaller than a critical angle, and therefore the exit light from the light-emitting layer 21 is refracted at a predetermined refraction angle on the boundary surface, to be emitted toward the air layer 8 side. In addition, the color filter 58 intervenes between the translucent portion 56 and the transparent substrate 55, so the color purity of light emitted from each of the light-emitting devices 21R, 21G, and 21B is improved by the colored layers 58R, 58G, and 58B, and therefore the contrast is improved.

Here, the display apparatus 20 according to the first embodiment described above and the display apparatus 50 according to the comparative example are compared. With reference to Fig. 1, in the light extraction device 23 in the display apparatus 20 of this embodiment, the colored layer 28a, the transparent layer 28b, and the transparent substrate 25 are arranged in this order from the light-emitting layer 21 side toward the air layer 8 side. The colored layer contains the colorant (pigment, die), and therefore has a higher refractive index than the transparent layer in general. Accordingly, light emitted from the light-emitting layer 21 passes from a layer having a high refractive index to a layer having a low refractive index when passing through the light extraction device 23. Thus, it becomes possible to reduce a reflection loss of light on a layer interface and increase the extraction efficiency to the air layer 8.

On the other hand, in the light extraction device 53 in the display apparatus 50 of the comparative example, the translucent portion 56 (transparent layer), the colored layers 58R, 58G, and 58B (color filter 58), and the transparent substrate 55 are arranged in this order from the light-emitting layer 21 side toward the air layer 8 side. In this case, light emitted from the light-emitting layer 21 causes a larger reflection loss on the interface between the translucent portion 56 and the color filter 58 as compared to the case of the light extraction device 23 described above. As a result, regarding the display apparatus 50 according to the comparative example shown in Fig. 11, the light extraction efficiency to the air layer 8 is degraded as compared to the display apparatus 20 according to the embodiment shown in Fig. 1.

Further, in the light extraction device 53 according to the comparative example, the bonding layer 54 intervenes between the translucent portion 56 and the colored layer (color filter 58). As a thickness of the bonding layer 54 becomes larger, the amount of light that can be reflected by the reflection film 57 is reduced. As a result, the light extraction efficiency to the air layer 8 side is degraded, and a brightness in an oblique direction is decreased.

The inventor of the present invention assayed rates of improvement of the light extraction efficiency in simulation with the display apparatus (Fig. 9) having the structure in which the color filters are layered on the light exit surface of the light-emitting layer being a reference. As a simulation model of the display apparatus 50 according to the comparative example, two kinds of a sample including the bonding layer 54 whose thickness is 3 um (Comparative Example 1) and a sample including the same whose thickness is 10 µm (Comparative Example 2) were assayed. A result in the simulation model of the display apparatus 50 according to Comparative Example 1 shows 41.4%, and a result in the simulation model of the display apparatus 50 according to Comparative Example 2 shows 32.8%. In contrast, a result in the simulation model of the display apparatus 20 according to the embodiment shows 46.3%.

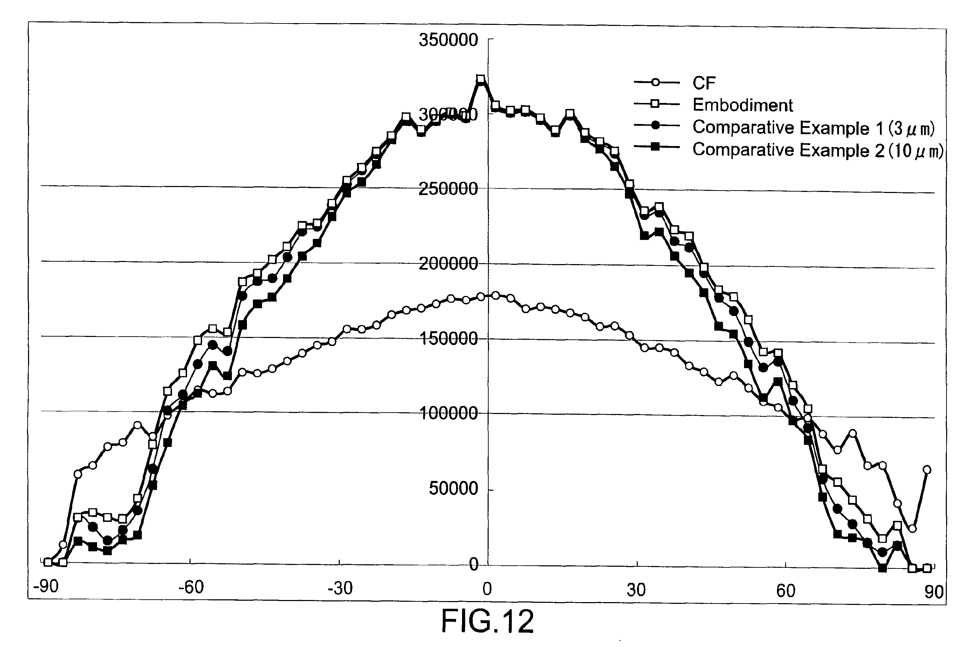

As a reference, an example of a simulation result that shows brightness distribution characteristics of light extracted to the air layer is shown in Fig. 12. In the figure, white circles indicate the brightness distribution characteristics in a case where the display apparatus (Fig. 9) having the structure in which the color filters (CF) were layered on the light exit surface of the light-emitting layer was used as the simulation model. In addition, white squares indicate the brightness distribution characteristics in a case where the display apparatus (Fig. 1) according to the embodiment was used as the simulation model. Further, black circles and black squares respectively indicate the brightness distribution characteristics in cases where the display apparatus (Fig. 11) according to Comparative Example 1 and Comparative Example 2 were used as the simulation models. From Fig. 12, it was confirmed that the simulation model according to the embodiment has a higher brightness in the oblique direction than those of Comparative Example 1 and Comparative Example 2.

According to this embodiment, there is no gap between the translucent portion and the colored layer that corresponds to the thickness of the bonding layer 54 as in the comparative examples. Therefore, it is possible to increase the reflection amount of light by the reflection surface (reflection film 27) and thus increase the light extraction efficiency. In addition, it is possible to increase the brightness not only in the front direction but also in the oblique direction.

As described above, the embodiment of the present invention is described. Of course, however, the present invention is not limited to this, and can be variously changed based on the technical idea of the present invention.

For example, although one translucent portion 26 is disposed for one pixel (one light-emitting device) in the above embodiment, a plurality of translucent portions may be disposed in one pixel region. Further, the structures 28 that constitute the translucent portion 26 are each formed into the same shape. However, the shape is not limited to one, and structures having a plurality of kinds of shapes may constitute the translucent portion of the light extraction device.

Further, in the above embodiment, the molding substrate 31 for forming the structures 28 that constitute the translucent portion 26 is formed by the metal mold, but is not limited to this. For example, a plastic sheet with flexibility that is excellent in detachability is used as the molding substrate, thereby making it possible to enhance the transfer property of the structures 28 to the transparent substrate 25.

Further, in the above embodiment, the transparent layer 28b is formed without curing the colored layer 28a, but the colored layer 28a may be cured or temporarily cured before the transparent layer 28b is coated.

### Brief Description of Drawings

[Fig. 1] A schematic cross-sectional diagram of a display apparatus including a light extraction device according to a first embodiment of the present invention.
[Figs. 2] Cross-sectional diagrams each showing a modified example of a structure constituting a translucent portion of the light extraction device according to the first embodiment of the present invention.
[Figs. 3] Cross-sectional diagrams each showing a modified example of the structure constituting the translucent portion of the light extraction device according to the first embodiment of the present invention.
[Figs. 4] Cross-sectional diagrams each showing a process of a main portion for explaining a manufacturing method of the light extraction device according to the first embodiment of the present invention.
[Fig. 5] A cross-sectional diagram for explaining a part of a manufacturing process of the light extraction device according to the first embodiment of the present invention.
[Figs. 6] Cross-sectional diagrams each showing a process of a main portion for explaining the manufacturing method of the light extraction device according to the first embodiment of the present invention.

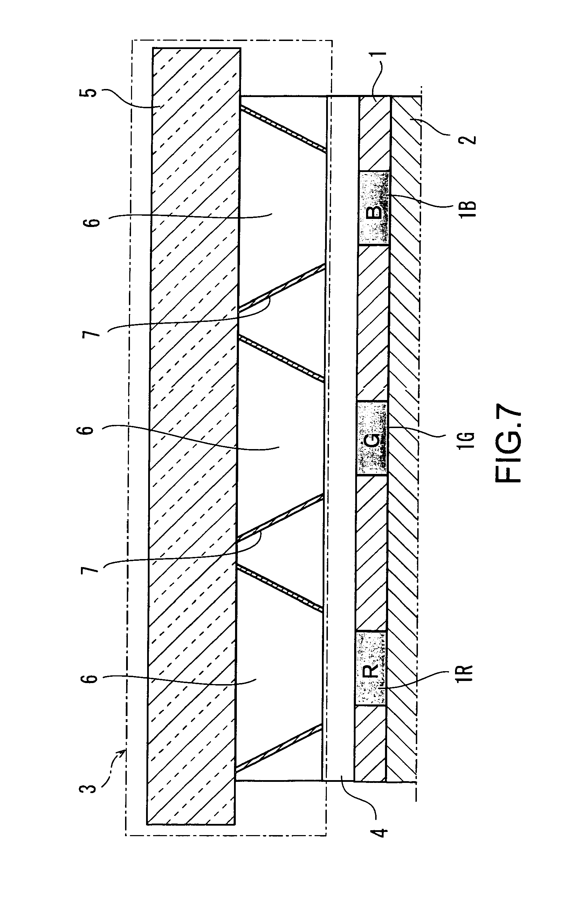

[Fig. 7] A schematic cross-sectional diagram showing a conventional display apparatus including a reflector function.
[Figs. 8] Cross-sectional diagrams of a main portion for explaining the reflector function of the display apparatus shown in Fig. 7.
[Fig. 9] A schematic cross-sectional diagram showing a conventional display apparatus including a color filter function.
[Fig. 10] A schematic cross-sectional diagram showing a display apparatus including a light extraction device according to a second embodiment of the present invention.
[Fig. 11] A schematic cross-sectional diagram showing a display apparatus including a light extraction device according to a comparative example.
[Fig. 12] A simulation result showing an example of a brightness orientation distribution of the display apparatus according to the first embodiment of the present invention and the display apparatus according to comparative examples.

### Description of Symbols

- 8: air layer
- 20, 40: display apparatus
- 21: light-emitting layer
- 21R, 21G, 21B: light-emitting device
- 23, 43: light extraction device
- 24: bonding layer
- 25, 45: transparent substrate
- 27, 47: reflection film (reflection surface)
- 28, 48: structure
- 28a, 48a: colored layer
- 28b, 48b: transparent layer
- 29, 49: light-shielding portion
- 30: space portion
- 31: molding substrate
- 32: concave portion

## Claims

1. A light extraction device disposed on a light exit surface of a light-emitting layer, comprising:
a translucent portion containing a colorant, to cause light emitted from the light-emitting layer to pass therethrough; and
a reflection surface formed on a periphery of the translucent portion, to change an exit angle of the light from the light-emitting layer.

2. The light extraction device according to claim 1,
wherein the translucent portion includes
a structure having a side peripheral surface and made of a translucent resin,
a reflection film formed on the side peripheral surface of the structure, and
a colored layer to constitute at least a part of the structure.

3. The light extraction device according to claim 2,
wherein the colored layer is formed by dispersing or dissolving a colorant into the translucent resin.

4. The light extraction device according to claim 3,
wherein the translucent resin is formed of an energy beam curable resin.

5. The light extraction device according to claim 3,
wherein the structure is formed so that a refractive index thereof is gradually reduced from a side of the light exit surface to a side of the transparent substrate.

6. The light extraction device according to claim 1,
wherein the reflection surface is formed into a plane or curved surface shape.

7. The light extraction device according to claim 1,
wherein the translucent portion is two-dimensionally arranged in a plurality of numbers,
the light extraction device further comprising a light-shielding portion formed between the translucent portions adjacent.

8. The light extraction device according to claim 7, further comprising:
a transparent substrate to support the plurality of translucent portions.

9. A method of manufacturing a light extraction device, comprising:
preparing a molding substrate in which a plurality of concave portions are two-dimensionally arranged on a surface thereof;
supplying a translucent resin containing a colorant into the concave portions;
curing the translucent resin to be transferred onto a transparent substrate; and
forming a reflection film on a side peripheral surface of a structure made of the translucent resin cured.

10. The method of manufacturing a light extraction device according to claim 9,
wherein the step of supplying the translucent resin containing the colorant into the concave portions includes
a step of dropping the translucent resin containing the colorant into the concave portions, and
a step of filling the concave portions with a translucent resin that does not contain the colorant.

11. The method of manufacturing a light extraction device according to claim 10,
wherein an energy beam curable resin is used for the translucent resin.

12. The method of manufacturing a light extraction device according to claim 10,
wherein the dropping of the translucent resin containing the colorant is performed by a ink-jet method.

13. The method of manufacturing a light extraction device according to claim 9, further comprising:
forming a black material layer between the structures adjacent, after the structure is transferred onto the transparent substrate and before the reflection film is formed.

14. A display apparatus, comprising:
a light-emitting layer;
a translucent portion containing a colorant, to cause light emitted from the light-emitting layer to pass therethrough; and
a reflection surface formed on a periphery of the translucent portion, to change an exit angle of the light from the light-emitting layer.

15. The display apparatus according to claim 14, further comprising:
a bonding material layer to bond the light extraction device with the light-emitting layer.

16. The display apparatus according to claim 14,
wherein the light-emitting layer includes a plurality of light-emitting pixel regions, and
wherein the translucent portion is arranged in a plurality of numbers to correspond to the plurality of the light-emitting pixel regions.
